Europäisches Patentamt

European Patent Office

Office européen des brevets

(11) Publication number: **0 156 440**
**B1**

# EUROPEAN PATENT SPECIFICATION

(45) Date of publication of patent specification: **24.01.90**

(51) Int. Cl.⁵: **H 03 M 13/00,** H 03 M 13/22 // G11B20/18, G06F11/10

(21) Application number: **85200431.6**

(22) Date of filing: **20.03.85**

(54) **An information transmission method with error correction for user words, an error correcting decoding method for such user words, an apparatus for information transmission for use with the method, a device for information decoding for use with the method and an apparatus for use with such device.**

(30) Priority: **24.03.84 JP 57595/84**
**24.03.84 JP 57596/84**

(43) Date of publication of application:
**02.10.85 Bulletin 85/40**

(45) Publication of the grant of the patent:
**24.01.90 Bulletin 90/04**

(84) Designated Contracting States:
**AT BE CH DE IT LI NL SE**

(56) References cited:
**EP-A-0 074 644**
**WO-A-83/01334**

**PATENTS ABSTRACTS OF JAPAN, vol. 7, no. 292 (E-219)1437r, 27th December 1983; & JP-A-58 168 346 (SONY K.K.) 04-10-1983**

**ELECTRONICS & COMMUNICATIONS IN JAPAN, vol. 64, no. 5, May 1981, pages 20-30, Scripta Publishing Co., Silver Spring, Maryland, US; M. OHKUBO et al.: "On interleaved codes for error-correcting codes"**

(73) Proprietor: **N.V. Philips' Gloeilampenfabrieken**
**Groenewoudseweg 1**
**NL-5621 BA Eindhoven (NL)**

(72) Inventor: **Suzuki, Tadao**
**c/o INT. OCTROOIBUREAU B.V. Prof. Holstlaan 6**
**NL-5656 AA Eindhoven (NL)**
Inventor: **Sako, Yoichiro**
**c/o INT. OCTROOIBUREAU B.V. Prof. Holstlaan 6**
**NL-5656 AA Eindhoven (NL)**
Inventor: **Furukawa, Shunske**
**c/o INT. OCTROOIBUREAU B.V. Prof. Holstlaan 6**
**NL-5656 AA Eindhoven (NL)**
Inventor: **Furuya, Tsuneo**
**c/o INT. OCTROOIBUREAU B.V. Prof. Holstlaan 6**
**NL-5656 AA Eindhoven (NL)**
Inventor: **Baggen, Constant Paul Marie Jozef**
**c/o INT. OCTROOIBUREAU B.V. Prof. Holstlaan 6**
**NL-5656 AA Eindhoven (NL)**

(74) Representative: **Strijland, Wilfred et al**
**INTERNATIONAAL OCTROOIBUREAU B.V. Prof. Holstlaan 6**
**NL-5656 AA Eindhoven (NL)**

(56) References cited:
JOURNAL OF THE AUDIO ENGINEERING
SOCIETY, vol. 27, no. 12, December 1979, pages
975-981, New York, US; T.T. DOI et al.: "A
long-play digital audio disk system"

ELECTRONIC COMPONENTS AND
APPLICATIONS, vol. 4, no. 3, May 1982, pages
131-141, Eindhoven, NL; J. MATULL: "ICs for
compact disc decoders"

ELECTRONICS INTERNATIONAL, vol. 57, no. 8,
April 1984, pages 85,86, New York, US; C.L.
COHEN: "Laser disks may be used as computer
ROMs"

## Description

The invention relates to an information transmission method with error correction for user words, an error correcting decoding method for such user words, an apparatus for information transmission for use with the method, a device for information decoding for use with the method, and an apparatus for use with such device, said information transmission method comprising the steps of:

a. dividing each user word into a first and a second multibit user symbol of mutually equal lengths;

b. introducing a succession of first numbers of data symbols into a first Reed-Solomon encoder for adding to each first number a first series of parity symbols, wherein said data symbols are generated from said user symbols;

c. interleaving the output symbols of the first encoder by means of respective different delay times over as many of second numbers as there are symbols in a said first number plus associated first series;

d. encoding a second number of symbols in a second Reed-Solomon encoder for adding to each second number a second series of parity symbols, to produce a third number of code symbols;

e. modulating said code symbols into channel symbols for introduction into a medium for later decoding.

An encoding method according to the above is known from British Patent, GB—2 076 569. Likewise, a modulating method according to the above is known from British Patent, GB—2 083 322. These two patents relate to the so-called "Compact Disc", which is an optically readable record for high quality audio data. This same system, with modified values for the constraining parameters, such as Hamming-distances, interleaving pattern, frame format, channel bit run lengths, and with modified technology may find wider use than the "Compact Disc" alone. In this respect the medium may be a master "Compact Disc", a replicated copy thereof, a digital audio tape, a broadcast transmission line, or other.

It has been found that the "Compact Disc" storage medium or other media referred to hereabove are also suitable for the inexpensive storage of digital data that do not directly relate to audio data. Examples of such other data are character data, display data or program data. In this way, it will be possible to realize a playback apparatus for reproducing visual information such as charts or graphics, pictorial illustration by still pictures, or a video game apparatus. Another useful application would be the distribution of software for personal or business computers. In both instances the addition of a video display unit would widen the application range of such "Compact Disc" or other storage system. Moreover, it is well-known that software must be frequently updated and the "Compact Disc" is of a conveniently reproducible and shippable format. It is envisaged that some applications could diverge from the audio system constraints. For example, the constant linear velocity of an audio system may be interchanged for a constant angular velocity of a data processing system. The former would be chosen for maximum storage density, the latter would allow for easier random access features. The data storage capacity of the "Compact Disc" is about 500 Mbyts which is much larger than the capacity of a magnetic floppy disk. The above advantages and uses could also apply to other transmission media or systems. Now, in the "Compact Disc" system a user word or audio sample of 16 bits is divided into two user symbols: the more significant eight bits and the less significant eight bits. The interleave, de-interleave, encoding and decoding using the Reed-Solomon codes are all carried out on a byte unit basis. Therefore, the same error correction processing can be executed both with respect to digital audio signals and digital data. If for audio information the error correction capability would sometimes be insufficient, a final remedy would be interpolation of missing samples between neighbours or some other error "concealment" algorithm. However, there is not sufficient correlation between successive program data or the like, and in such cases interpolation would be little useful. Therefore, a code of last resort should be introduced as an overlay on the Reed-Solomon codes of the preamble.

It is therefore an object of the present invention to provide a method of transmitting data wherein the "Cross-Interleaved Reed-Solomon Code" pair is supplemented with a further error protection code, wherein all processing is done on symbols of relatively short lengths. The symbol, which typically consists of eight bits, is easy to handle. Processing a longer symbol, e.g. sixteen bits would be a lot more complicated. The object of the invention is realized in that said data symbols are generated by sector-wise adding to said user symbols a third series of parity symbols in a third Reed-Solomon encoder, and in that each sector after encoding consists of data symbols equal in number of those of an entire plurality of first numbers of data symbols.

Preferably, each user word is divided into a more significant user symbol and a less significant user symbol, and in that said sectors are organized in two planes in that a first plane of a sector receives the more significant user symbols of the sector and the second plane receives the less significant user symbols of said sector. In this way, user symbols are distributed in more significant "planes" and less significant "planes". It has been found that this procedure allows for correction of so-called burst errors on the medium of an increased maximum length, as simulations have proved.

Preferably, said third series is organized into a first plurality of mutually exclusive first subseries and a second plurality of mutually exclusive second subseries, and in that each first subseries (P) is added to an exclusive first part of the user symbols of the sector in question with respect to all other first subseries, and in that each second subseries (Q) is added to an exclusive second part of the user symbols of the sector in question cum associated first subseries of parity symbols with respect to all other second subseries, and in

3

that all symbols of a said first part are contained in mutually unique second parts, and vice versa. This pseudo-product-code is simple to correct and proves to increase the overall correction capability dramatically.

Preferably, each subseries consists of two parity symbols. Even with this very limited amount of redundancy included in every subseries, a good performance results. It should be noted that the complications of error correction quickly increase with the length of each subseries.

Preferably, an additional multisymbol error detection quantity is included within a sector of data symbols. In this way, failure of the error protection is signalled in a very reliable way.

Preferably, said error detection quantity is a multisymbol cyclic redundancy check (CRC) quantity. CRC algorithms have proved both reliable and elementary.

The invention also relates to an error correcting decoding method for user words according to the above, to an apparatus for information transmission for use with the method, to a device for information decoding and to an apparatus for use with such a device, as have been recited in further Claims.

## Brief description of the figures

The invention will be furthermore explained with reference to the accompanying Figures.

Figure 1 shows the data format on the compact optical disc;

Figure 2 shows a general set-up of a decoder;

Figure 3 shows the format of a notional information unit for explaining the (de)coding organization;

Figure 3a shows a different version of the organization;

Figure 4 is a schematic diagram showing an arrangement of one sector on a byte unit basis;

Figure 5 is a schematic diagram showing an arrangement of one sector on a word unit basis;

Figures 6 and 7 are schematic diagrams which are used to explain the interleave relationship within one sector;

Figure 8 is a block diagram of an apparatus comprising a decoder;

Figure 9 is a diagram of the format of the reproduced data;

Figure 10 is a block diagram of an error correcting decoder.

## Description of the data format

By way of example, hereinafter, first the data format is described as used on a so-called "Compact Disc". It should be noted that the invention could well be used with other values of the format parameters. Notably, the number of bits within a symbol, the numbers of symbols in a sector or in a frame, or the numbers of parity symbols added in successive encoding stages could be different.

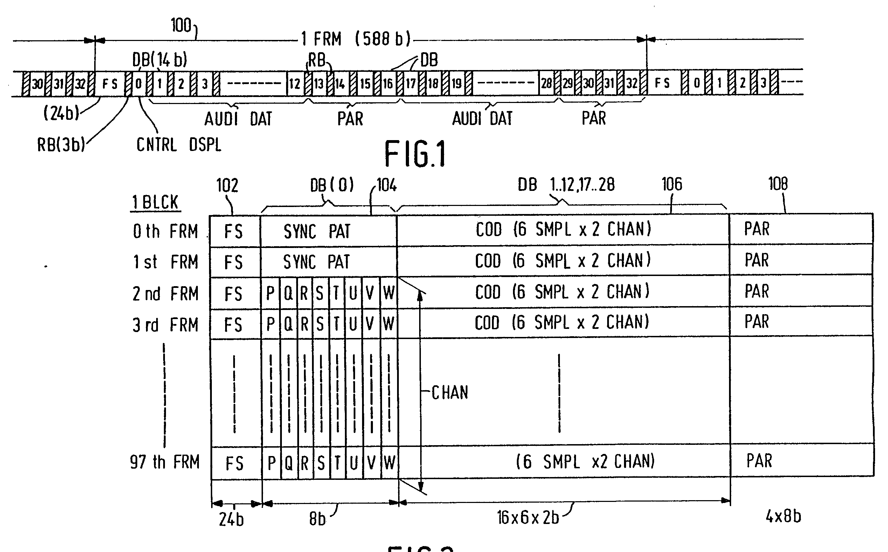

Now in Figure 1, a frame 100 comprises 588 recorded or channel bits. Each frame starts with a synchronization pattern FS of 24 bits. The synchronization pattern, and also all further information symbols are followed by groups of three so-called merging bits (shaded) which are added to diminish the DC-component of the recorded signal. The zeroeth information symbol is called a subcoding group of user bits. This subcode may be used to control the playback of a disc, to display content-related information, e.g. timing and addresses on a video display or for other useful purposes. Symbols numbered 1—12 and 17—28 are assigned for audio data. Symbols numbered 13—16 and 29—32 are assigned to parity symbols. Each of the recorded or channel symbols consists of fourteen channel bits, which during modulation are formed from code bits and which code bits during demodulation must been reformed again. For brevity, the (de)modulation process is not considered further.

## Overall description of the decoder

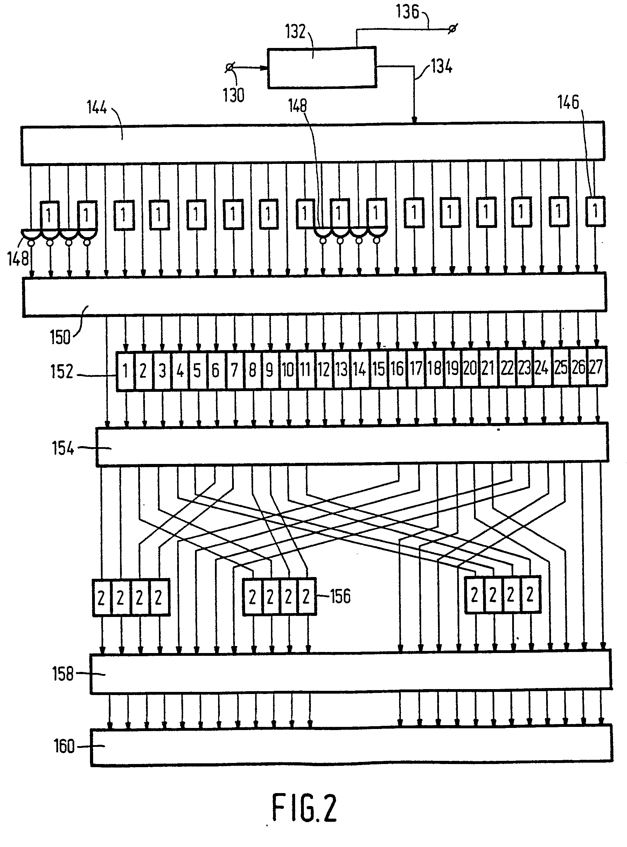

Figure 2 shows a decoder for use with the invention according to the format of Figure 1. The encoder to a large extent will be symmetric with the decoder and therefore, will not be elaborated to the same detail as the decoder. The channel symbols arrive on input 130 in a bit-serial manner. In demodulator 132, first a series-parallel conversion takes place. Next the 14-bit channel symbol is translated into an 8-bit code symbol. The 8-bit code symbol is ouputted on interconnection 134. Under certain circumstances additional flag information may be outputted on interconnection 134 to signal whether the conversion was impossible or doubtful. The merging bits may, or may not be taken into account for determining the flag information. Generally, the synchronization of the various modules is not taken into account here. The control symbol may be demodulated in a similar way as the other symbols. A branch-off 136 is present for forwarding the control symbol to a control mechanism not shown.

Next, block 144 represents a multiplexer with a single input 134 and thirty-two parallel outputs. This parallellism may be executed in the time domain, e.g. in that successive incoming symbols are stored on successive locations of a processing RAM. Multiplexing is done on the basis of symbols, so that each output of block 144 receives one symbol. Blocks like block 146 delay the symbols received for one frame interval. A frame has been disclosed with respect to Figure 1. Elements such as 148 are invertors for bitwise inverting parity symbols. Element 150 is a decoder for decoding, and if applicable, correcting a group of 32 symbols received by means of the second Reed-Solomon code. Thus, on the output of decoder 150 for each group of 32 symbols received, there is a group of 28 symbols outputted. If required, each symbol may be provided with its own reliability flag or flags. The blocks 152 which are denoted by reference numerals 1 to 27 introduce respective delays to introduce a de-interleaving effect. The numeral in the block indicates the delay expressed in a number of frame intervals. A "1" indicates four such intervals, a "2" eight intervals, etcetera. Each symbol of a group of 28 symbols output together by element 150 is therefore assigned to a respective newly formed group of 28 symbols. In case of a burst error in the medium, such burst has its effect spread over a large time interval, causing in general each newly formed group to contain few errors only.

Element 154 is a decoder for executing decoding, and if applicable, correcting a group of 28 symbols received, by means of the first Reed-Solomon code. Thus, on the output of decoder 154 for each group of 28 symbols received there is a group of 24 symbols outputted. If required, each such symbol outputted is again provided with its own reliability flag or flags. The block 156 which are denoted by reference numerals 2 introduce respective delays to introduce a descrambling effect. The numeral 2 indicates that the delay is over two frame intervals. Furthermore, also within a frame a certain sequential re-ordering of the symbols is effected as shown by the crossing lines. In an audio application, this descrambling ensures better possibilities for concealing the effects stemming from uncorrectable symbols. In that case, an odd-numbered symbol and its even-numbered successor together constitute a 16-bit audio sample. After D/A conversion, a missing analog sample may be reconstituted by means of some interpolating algorithm between correct neighbouring samples.

Block 158 represents a memory for the corrected symbols, together with associated flag information. These symbols are stored until a so-called sector is present. Finally, element 160 is a decoder for decoding, and if possible correcting, the information of a sector. The corrected user symbols are now presented in conventional manner to a user device not shown.

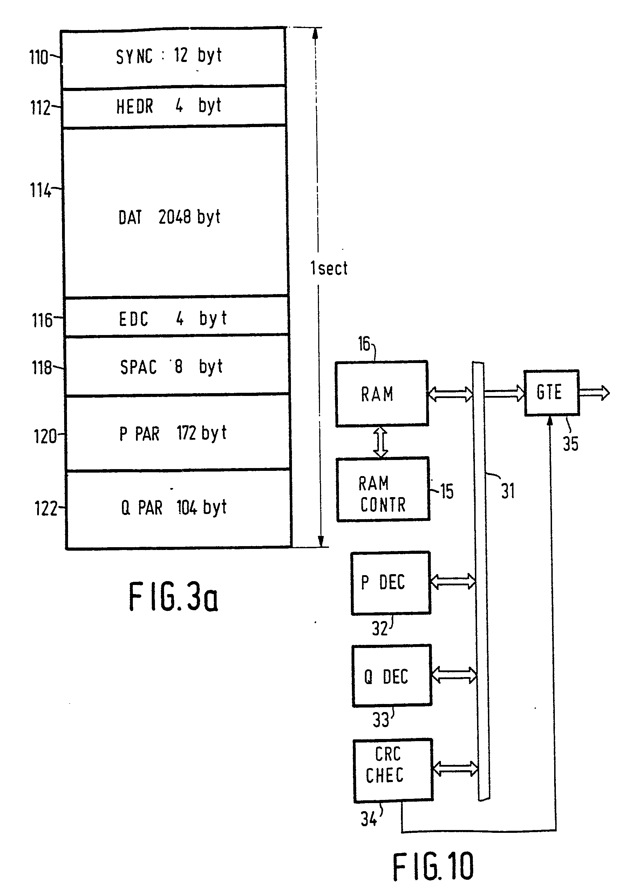

Figure 3 shows the combined content of 98 successive frames received at input 130 in Figure 2 wherein each frame covers one line in the Figure. Due to the combined effect of delay elements 146, 152, 156 this does not correspond to the actual contents of a sector to be discussed with respect to later Figures. The merging bits are not shown as it is supposed that demodulation has taken place. Column 102 shows the 98 successive synchronization pattern FS. The second column 104 DB(0) shows the content of the zeroeth symbol of the frame. The third column 106 represents the content of data symbols 1—12, 17—28 of the frame. The fourth column 108 represents the content of the eight parity symbols RB with each frame. In an audio system, the 24 data symbols of each frame represent six stereophonic samples of 2×16 bits each. In the zeroeth and first frames the subcoding symbol (column 104) forms a synchronization pattern SYNCPAT, which has a predetermined format. This is used to produce synchronisation for the subcode on the level of a sector.

According to the "Compact Disc" format, the P-channel (the combined first bit of successive subcode symbols from second through 97th frame) constitute a flag to discriminate between a music program and a pause. It has a low level during a music program, a high level during a pause, and switches at a 2 Hz frequency in the lead-out section. Therefore, it is possible to select specific music by counting this signal. The Q-channel enables further control of this type. When the Q-channel information is stored in a microcomputer provided in the disc player it is possible to step from one music program to another to provide a certain random access feature at an accuracy of 1/75th of a second. The channels R. W. may contain digitally coded speech as additional information to the audio signal.

In the Q-column, the first two bits are used for the synchronization in SYNCPAT. The next four bits are used as control bits. The following four bits are used as address bits. The following 72 bits are used as data bits. These may include a track number code TNR and an index code X. Both codes may vary from decimal 00 to decimal 99. Further the data include a time indication code giving the duration of a music program and a pause, and time indication code giving the absolute running time from the front end of the program area of the "Compactc Disc". These time indication codes give minutes seconds and frames each in two decimal digits. One second is divided into 75 frames. To access the compact disc on the basis of a unit which is shorter than a music program such as in digital data, the above-mentioned absolute time code is used as an address. Finally, the last sixteen bits of the Q-channel are available for an error detection code by means of a CRC-check.

In the present embodiment, when the digital data is recorded as the data DB, the format of the subcoding channels P, Q is the same as in the "Compact Disc" system. After the decoding of the first and second Reed-Solomon codes and the descrambling in elements 156, if applicable, the data (column 106 in Figure 3) is grouped into a sector. The length of a sector corresponds to the user information of 98 frames, which is 2352 bytes. Figure 3a shows the function of the respective elements of a sector. A sector in the first place comprises a sector synchronization signal of 12 bytes (110). Next there is a header information 112 of 4 bytes. Next there are 2048 user bytes 114. Next, there is an error-detection code EDC 116 of four bytes. This code is based on the CRC principle and must not be confused with the 16-bit CRC code in the Q-channel of Figure 3. Next there is a space 118 of eight bytes for later extension of functions. Next, there are 172 P-parity bytes 6120) and 104 Q-parity bytes (122) of the third Reed-Solomon code. The total information of one sector can be fetched together in decoder 160.

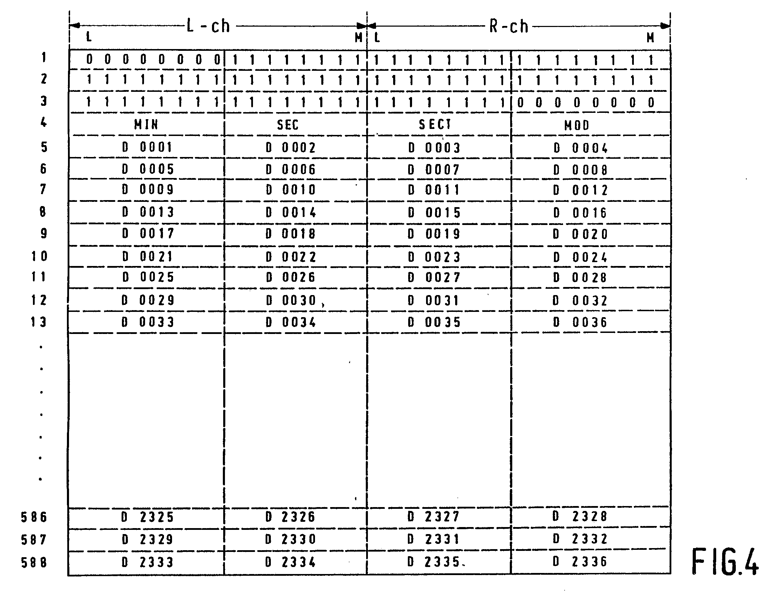

Figure 4 shows the more detailed arrangement of one SECTOR. In Figure 4, the left channel and right channel correspond to the sample data in the left and right channels of the stereophonic audio data. In each channel., one word consists of 16 bits and L denotes the least significant bit and M indicates the most significant bit. As mentioned above, in case of the stereophonic audio data, the data of (6×2×2=24 bytes) have been recorded in the interval which is specified by the frame sync signal. Therefore, when the digital

5

data is recorded in the same signal format (Figure 1) as the stereophonic audio data, one sector (2352 bytes) is recorded in the 0th to 97th of the frames as they are numbered according to the subcode content (subcode-frames). Thus, the digital data (DB) of a sector has a length corresponding to the interval between two successive zero-frame synchronization patterns (SYNCPAT) of the subcode signal. There is no interleaving between different sectors.

The first byte of the digital data of a sector has the bits all "0"; the following ten bytes have the bits all "1"; the twelfth byte has the bits all "0". This 12-byte interval is a sector sync signal indicating the head of a sector. After the sector sync signal, headers regarding minutes MIN, seconds SEC, sector SECT, and mode MOD each of one byte are added.

These headers are the address of one sector and 75 sectors correspond to one second similarly to the subcode frame. The mode data indicate the kind of data of a SECTOR. In Figure 4, D0001 to D2336 represent the byte numbers of a sector excluding the sector sync signal and headers. D0001 to D2048 are for the user data; D2049 to D2052 are for the error detection code; D2053 to D2060 are for a space; D2061 to D2232 are for the P-parity; and D2233 to D2336 are for the Q-parity.

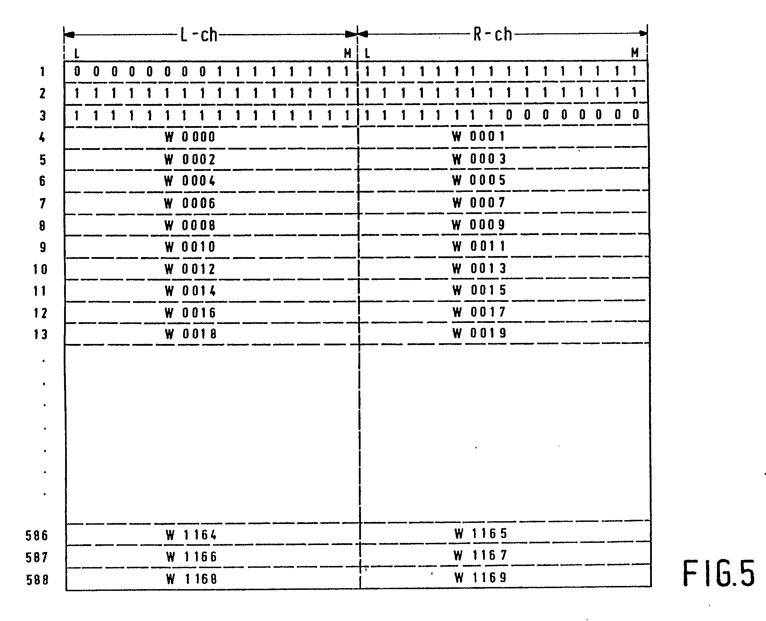

Figure 5 shows an arrangement of one sector expressed on a word unit basis. In Figure 5, W0000 and W0001 are for the headers; W0002 to W1025 are for the user data; W1026 and W1027 are for the error detection code; W1028 to W1031 are for a space; W1032 to W1117 are for the P-parity; and W1118 to W1169 are for the Q-parity. The error detection code covers the header and user data (W0000—W1027) and also the twelve synchronization bytes. The error correction code covers the header and user data (W0000—W1027) and also the P-parity and Q-parity itself and also the CRC bits and the space 118 (but not the synchronisation bytes).

A CRC-code which is used as the error detection code has, for example, the following generating polynomial g(x).

$$g(x)=(x^{16}+x^{15}+x^2+1)(x^{16}+x^2+x+1).$$

The CRC-code is a binary code with symbols from Galois-field GF(2). This error detection code is used to check the final reliability after the execution of the error correction. This check may be executed both with respect to the decoding with the cross-interleaved Reed-Solomon codes and with the sector-based pseudo-product-Reed-Solomon code. The CRC code would thus signal a failed correction, to a user device.

Each word W0000—W1169 of a SECTOR is divided into two bytes, the more signifant byte and the less significant byte. The more significant 1170 bytes are grouped into a first data plane, while the less significant 1170 bytes are grouped into a second data plane. The sector-wise error correction processing is executed for each of these data planes separately. The coding processing for the respective data planes is, however, identical.

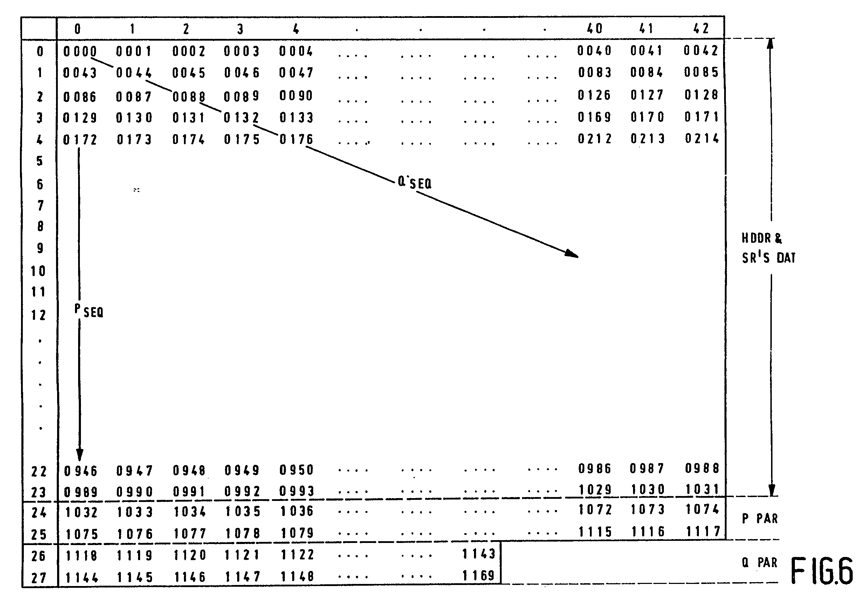

Figure 6 is a diagram for explaining the encoding regarding either data plane. The data plane consists of 1032 bytes comprising the header and user data and the CRC and space data and these 1032 bytes are notionally arranged like a matrix of (24×43) bytes. For convenience, the bytes are identified by the word number of the associated word. These sector-wise organized bytes are encoded into a further set of two Reed-Solomon codes. The matrix-type depiction in this Figure shows the interleaved organization of the two latter codes in different directions in the matrix.

Now the following Reed-Solomon code is used according to the columns of Figure 6. This code has a code word length of 26 symbols and a so-called dimension of 24 symbols. The associated P-parity symbols are shown in rows 24, 25 at the lower end of the Figure. The associated Galois-field $GF(2^8)$ may be generated by the primitive polynomial

$$P(x)=x^8+x^4+x^3+x^2+1.$$

The associated primitive element a=(00000010), the latter bit being the least significant. The generator for the code is given by the product $(x-a^0)(x-a^1)$. The parity check matrix HP for this code is as follows:

$$HP= \begin{bmatrix} 1 & 1 & 1 & \ldots 1 & 1 \\ a^{25} & a^{24} & a^{23} & \ldots a^1 & 1 \end{bmatrix}$$

Assuming that the P-series after decoding is *VP*, the parity symbols $P0_{NP}=D(43\times24+NP)$ and $P1_{NP}=(43\times25+NP)$ (NP=0, 1, 2, ..., 41, 42) will satisfy the following equation.

$$HP \times VP = 0$$

where,

$$VP= \begin{bmatrix} D(43\times0 \ +NP) \\ D(43\times1 \ +NP) \\ D(43\times2 \ +NP) \\ \\ D(43\times MP+NP) \\ \\ D(43\times24 \ +NP) \\ D(43\times25 \ +NP) \end{bmatrix} \quad \text{(Here NP=0 .. 42, MP=0 .. 25)}$$

As an example, when N=0, one reproduced P-parity is generated upon [D0000, D0043, D0086, D0129, D0172, . . ., D0946, D0989, D1032 (=P0), D1075 (=P1)] that are located in the first column.

A further Reed-Solomon code is used according to the diagonal direction as given by the arrow QSEC in Figure 6. This code has a code word length of 45 bytes or symbols and a dimension of 43 symbols. The associated Q-parity symbols are shown in the two rows QPAR at the lower end of the Figure. In this case, there are 26×2 parity symbols (as many pairs as there are user symbols thus P-parity symbols in any column). The polynomial P(x) is the same, the parity check matrix is:

$$HP= \begin{vmatrix} 1 & 1 & 1 & ...1 & 1 \\ a^{44} & a^{43} & a^{42} & ...a^{1} & 1 \end{vmatrix}$$

When the reproduced Q-series is VQ, the parity symbols X0=D(43×26 +NQ) and Q1=D(44×26+NQ) satisfy the following equation: HP×VQ=0, where

$$VQ= \begin{bmatrix} D(44\times0 \ +43\times NQ) \\ D(44\times1 \ +43\times NQ) \\ D(44\times2 \ +43\times NQ) \\ \\ D(44\times MQ+43\times NQ) \\ \\ D(44\times40 \ +43\times NQ) \\ D(44\times41 \ +43\times NQ) \\ D(44\times42 \ +43\times NQ) \\ D(44\times26 \ +NQ) \\ D(44\times26 \ +NQ) \end{bmatrix} \quad \begin{array}{l} \text{The ranges are:} \\ \text{NQ 0...25} \\ \text{MQ 0...42} \end{array}$$

When it is assumed that (NQ=0, 1, 2, 3, . . ., 24, 25) and (MQ=0, 1, 2, 3, . . ., 41, 42) and if there is the relation of (44×MQ+43×NQ)>1117, (44×MQ+43×NQ) will be calculated as (44×M+43×N−1118).

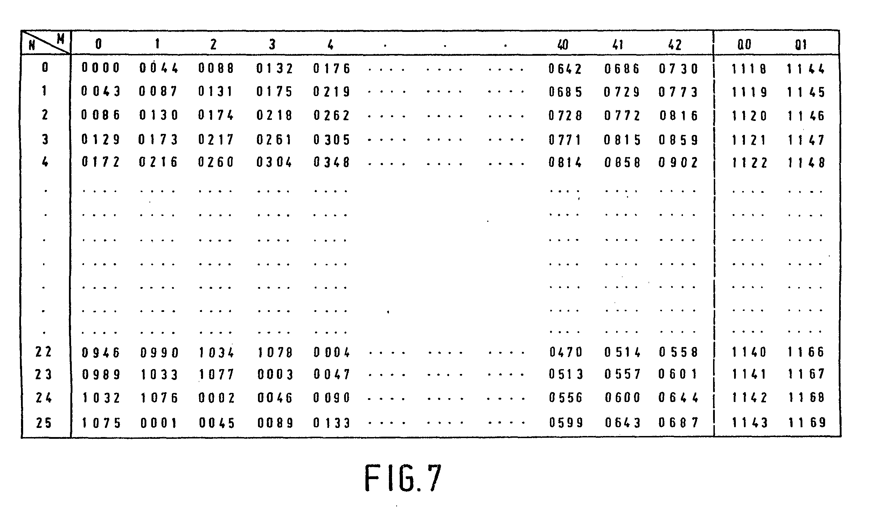

Figure 7 corresponds closely to Figure 6. Here, with respect to Figure 6, the column for M=1 has been rotated upward by one position, for M=2 by two positions, etcetera. The Q-parity symbols have been shown in two additional columns. In this way, the rows in Figure 7 each constitute their own Q-series. Again, each column forms a (now rotated) P-series, except for the Q0, Q1 columns. Therefore, Figure 7 shows the arrangement of a quasi product code using a (26, 24) Reed-Solomon code in the vertical direction and a (45, 43) Reed-Solomon code in the horizontal direction.

Since these two Reed-Solomon codes each have two parity symbols, even when no error flag exists, up to one symbol error can be corrected in each code sequence. When the error location is known by an error flag, up to two symbol errors can be corrected. This error flag may be produced by the decoding of the first and second Reed-Solomon codes. Now, by alternately performing the decoding of the Reed-Solomon code in the vertical direction (referred to as the P-decoding) in Figure 7 and the decoding of the Reed-Solomon code in the horizontal direction (referred to as the Q-decoding), for example, by performing (P-decoding; Q-decoding; P-decoding; Q-decoding) all error patterns can be corrected that have at most two flagged error symbols with respect to any of the P-series or Q-series or which, by initial processing, can be reduced thereto. The simplest pattern which cannot be corrected has three P-series with three error symbols each, which error symbols also occur three by three in only three Q-series. Additional errors would made the situation worse, of course.

The encoding is executed for the two data planes (containing the more significant and less significant bytes, respectively) in exactly the same way. The encoding acts upon the 1118 words of the header and user data and CRC-check bits and space bits of one sector.

The respective data planes after encoding are synthesized and the sector sync signal is added so that the arrangement of one sector shown in Figures 4, 7 is obtained. This sector is supplied to the encoder in place of audio data, for the cross interleave Reed-Solomon code (CIRC)-encoding of the "Compact Disc"; furthermore it is modulated into the channel data as shown in Figure 1. This channel data is supplied to the cutting machine for the digital disc. Secondary copies may be made by a conventional replicating process.

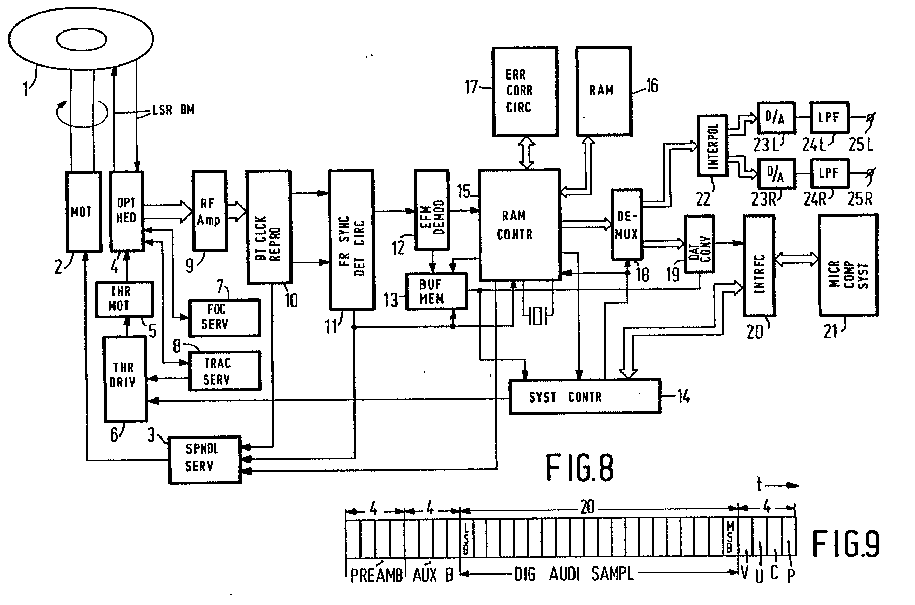

Figure 8 shows one embodiment of a decoding apparatus according to the invention. Herein, digital disc 1 has the digital signal recorded according to a spiral track. The disc 1 is rotated by spindle motor 2, which is speed-controlled by spindle servo circuit 3. An optical head 4 comprises: a laser generator for read out; a beam splitter; an optical system; and a photo sensitive element to receive the laser beam reflected by the disc 1. The optical head 4 can be moved in radial direction by a motor 5. Motor 5 is driven by a drive circuit 6. In addition, the optical head 4 can be moved in a direction perpendicular to the surface of disc 1 and in a direction parallel therewith. Focus servo circuit 7 and tracking servo circuit 8 are provided for controlling the correct focussing and tracking of optical head 4. Furthermore, optical head 4 is equipped with a known focus error and radial error detecting element.

The output signal of the optical head 4 is supplied to RF-amplifier 9. The output signal of the RF-amplifier 9 is supplied to a clock extracting circuit 10. The outputs (data and clock) of the clock extracting circuit 10 are supplied to a frame sync detecting circuit 11. The digital signal recorded on the disc 1 is modulated in known manner. A digital demodulator 12 performs the demodulation. The bit clock outputted from the clock extracting circuit 10 and the frame sync signal detected by the frame sync detecting circuit 11 are supplied to the digital demodulator 12 and the spindle servo circuit 3.

The subcoding signal is separated by the digital demodulator 12 and this subcoding signal is supplied to a system controller 14 through a buffer memory 13. The system controller 14 is equipped with a CPU and controls the rotating operation of the disc 1, drive 6 and, the read out operation of the optical head 4. Control commands are supplied through an interface 20 described later to the system controller 14. Controller 14 controls read out of the desired digital signal from the disc 1 while using the subcoding signal.

The main digital data outputted from the digital demodulator 12 is supplied through a RAM controller 15 to a RAM 16 and an error correcting circuit 17. The removal of the time base variation and error correction are executed by the RAM controller 15, RAM 16 and error correcting circuit 17, so that the main digital data is outputted. The output of the RAM controller 15 is supplied to a demultiplexer 18. The demultiplexer 18 is controlled in dependence on whether the disc 1 carries audio data without the Reed-Solomon code, or has this additional sector-wise code. In other systems the audio channel may be omitted and no multiplexer would be required. The multiplexer 18 is controlled by system controller 14. The control mode may be executed on the basis of the information in the subcode signal. The latter discrimination information is due signalled to RAM 16. In case of digital data storage the additional error correction can be undertaken (as far as necessary). Data converter 19 receives the digital data and also the reproduced subcode signal. The reproduced data is parallel-to-serial converted by data converter 19. Also, the subcoding signal is supplied from buffer 13 to data converter 19. Figure 9 shows an example of a word format of the serial signal which is outputted from the data converter 19. Herein one word consists of 32 bits in which the first four bits are for preamble, the next four bits are auxiliary bits of data and the next 20 bits are for data. The digital data of the user word are inserted with the least significant bit first. Four control bits are added. Bit V is a flag indicating the validity of the word. Bit U is a bit of the subcoding signal, so that all bits of the subcode signal are transmitted in series. Bit C is a channel discrimination bit. Bit P is a parity bit. This word format is defined in consideration of the audio data and is supplied to an interface 20 at the next stage and is converted to the data format for a standard computer. In addition, data for system controller 14 is supplied from microcomputer system 21 through interface 20. The microcomputer system provides the read out address and drive control signals such as the start signal.

An interpolator 22 is connected to the output path of the demultiplexer 18 which is selected when the disc to be played back is for the stereophonic audio signals thereby allowing the error data which could not be error corrected to the interpolated. The audio signals are divided into the signals is the left and right channels by the interpolator 22. The data in the respective channels are converted to the analog signals by D/A converters 23L and 23R and outputted through low-pass filters 24L and 24R.

The time base variation of the subcoding signal may be removed by the buffer memory 13, similarly to the time base corrections with respect to the digital signal in the main channel by the RAM controller 15 and RAM 16. The RAM controller 15 forms the write clock synchronized with the reproduction signal from the detected frame sync signal. The digital signal is written into the RAM 16 in response to this write clock. When the digital signal is read out from the RAM 16, the read clock is formed from the output of a crystal oscillator. Thus, write-in and read-out of the subcoding signal for buffer memory 13 is controlled. Consequently, the subcoding signal read out from the buffer memory 13 includes no time base variation.

In one embodiment of the invention, upon playback of the disc for the storage of digital data, the read command for a predetermined address is first given by the microcomputer system 21. This address is the code itself for the display of the absolute time in the Q-channel. This address is supplied to the system controller 14 through the interface 20. The system controller 14 controls the drive circuit 6, for moving the optical head 4 nearly to the desired read out location while checking the subcoding signal reproduced by the optical head 4. Then, the reproduction is started from the location which lies a few sectors earlier to prevent malfunction so that the accessing does not end without reproducing the intended subcoding signal because an error were included in the subcoding signal. The desired sector is caught either by the method whereby the reproduced subcoding signal coincides with the designated address or whereby the frame sync signal is counted by starting the reproduction from a near location of the correct subcoding signal.

Figure 10 shows an example of the error correcting circuit when the disc for the storage of digital data is played back. The error correcting circuit is used for both audio discs and for discs for the storage of digital data. The decoder for the CIRC code is not shown. Reproduced data (excluding the sector sync signal) of one SECTOR are stored in the RAM 16 after the data are decoded by the CIRC code. An error flag indicating presence or absence of an error is added to each symbol.

Each symbol is read out from the RAM 16 together with the error flag and is supplied through a data bus 31 to a P-decoder 32 for every P-series of 26 symbols. The P-decoder 32 performs the decoding using the (26, 24) Reed-Solomon code. The symbols after this decoding are written in the RAM 16. The error flag of a symbol of which the error was corrected by the P-decoder 32 is reset. After completion of the P-decoding with respect to one sector, the data read out from the RAM 16 is supplied through the data bus 31 to a Q-decoder 33.

The de-interleave is performed due to the address control of the RAM 16, and in the Q-decoder 33 the (45, 43) Reed-Solomon code is decoded. The error flag of a symbol of which the error was corrected, is reset. Next, the P-decoding is again performed and thereafter the Q-decoding is carried out again. In this way, after the P-decoding and Q-decoding were alternately performed twice each, the reproduced digital data after the error correction from the RAM 16 is supplied to a CRC checker 34, where the error detection is performed. The result of the error detection is supplied to an output gate 35. In the output gate 35 the error flag may inhibit the outputting of erroneous data. In other embodiments, a lower number or a higher number of P and/or Q decoding operations may be performed; for example, if no errors are detected in the beginning, the P and Q-decoding are skipped.

The error detection result can be also used for the error correction in the P-decoder 32 and Q-decoder 33. Upon error correction, the P-decoder 32 and Q-decoder 33 use the error flag which was generated in the decoding of the CIRC code. Now, when the CIRC flag mechanism indicates that an error exists, but the CRC check indicates a correct situation, further decoding of the third Reed-Solomon code is terminated.

## Claims

1. An information transmission method with error correction for user words, said method comprising the steps of:

a. dividing each user word into a first and a second multibit user symbol of mutually equal lengths;

b. introducing a succession of first numbers of data symbols into a first Reed-Solomon encoder for adding to each first number a first series of parity symbols, wherein said data symbols are generated from said user symbols;

c. interleaving the output symbols of the first encoder by means of respective different delay times over as many of second numbers of symbols as there are symbols in a said first number plus associated first series;

d. encoding a second number of symbols in a second Reed-Solomon encoder for adding to each second number a second series of parity symbols, to produce a third number of code symbols;

e. modulating said code symbols into channel symbols for introduction into a medium for later decoding;

characterized in that said data symbols are generated by sector-wise adding to said user symbols a third series of parity symbols in a third Reed-Solomon encoder, and in that each sector (Figure 3a) after encoding consists of data symbols equal in number to those of an entire plurality of first numbers of data symbols.

2. A method as claimed in Claim 1, characterized in that each user word is divided into a more significant user symbol and a less significant user symbol, and in that said sectors are organized in two planes in that a first plane of a sector receives the more significant user symbols of the sector and the second plane of said sector receives the less significant user symbols of said sector, and in that said third Reed-Solomon encoder is separately operative in each of said two planes from the respective other plane.

3. A method as claimed in Claim 1 or 2, characterized in that said third series is organized into a first plurality of mutually exclusive first subseries and a second plurality of mutually exclusive second subseries, and in that each first subseries (P) is aded to an exclusive first part of the user symbols of the sector in question with respect to all other first subseries, and in that each second subseries (Q) is added to an exclusive second part of the user symbols of the sector in question cum associated first subseries of parity symbols with respect to all other second subseries, and in that all symbols of a said first part are contained in mutually unique second parts, and vice versa.

4. A method as claimed in Claim 3, characterized in that each subseries consists of two parity symbols.

5. A method as claimed in any of Claims 1 through 4, characterized in that an additional multisymbol error detection quantity is included within a sector of data symbols.

6. A method as claimed in Claim 5, characterized in that said error detection quantity is a CRC check quantity.

7. An error correcting decoding method for user words that have been encoded according to the method of Claim 1, said method comprising the steps of:

a. receiving from a medium a sequence of channel symbols and therefrom by demodulation forming a sequence of third numbers of code symbols;

b. decoding, and if applicable, correcting a third number of code symbols into the associated smaller second number of symbols in a first Reed-Solomon decoder associated to the second Reed-Solomon encoder;

c. de-interleaving the output symbols of the first decoder by means of respective different delay times over as many fourth numbers of symbols as there are symbols in said second number, said second and fourth numbers having the same value;

d. decoding, and if applicable, correcting a fourth number of symbols to the associated smaller first number of symbols in a second Reed-Solomon decoder associated to the first Reed-Solomon encoder; characterized in that an entire plurality of said first numbers of symbols are combined into a sector for decoding, and if applicable, correcting said plurality in a third Reed-Solomon decoder associated to the third Reed-Solomon encoder to therefrom produce an output number of user symbols that is smaller than the number of symbols in a sector by at least the number of said third series of parity symbols.

8. An error correcting method as claimed in Claim 7, characterized in that said user symbols are pair-wise combined into user words, in that each user word consists of a more significant user symbol and a less significant user symbol, in that said sectors are organized in two planes in that a first plane of a sector comprises the more significant user symbols of the sector, and the second plane comprises the less significant user symbols of the sector, and in that said third Reed-Solomon decoder is separately operative in each of said planes from the respective other plane.

9. An error correcting method as claimed in Claim 7 or 8, characterized in that said third series of parity symbols is organized into a first plurality of mutually exclusive first subseries and a second plurality of mutually exclusive second subseries, and in that each first subseries is added to an exclusive first part of the user symbols of the sector in question with respect to all other first subseries, and in that each second subseries is added to an exclusive second part of the user symbols of the sector in question cum associated first subseries of parity symbols with respect to all other subseries, in that all symbols of a said first part are contained in mutually unique second parts, and vice versa, and in that the third Reed-Solomon decoder is separately operative for each of said first and second parts from any respective other first and second part.

10. An error correcting method as claimed in Claim 9, characterized in that said first and second subseries each consist of two symbols and in that with respect to at least one first or second part at least one symbol is rendered correctable by the associated subseries.

11. An error correcting method as claimed in any of Claims 7 through 10, characterized in that an additional multisymbol error detector quantity is included within a sector of data symbols, and in that upon decoding an insufficient error protection as detectable by said error detection quantity is signalled to a user device.

12. An apparatus for information transmission with error correction according to the method claimed in Claim 1, said apparatus comprising:

a. input means cum distributing means for receiving user words and distributing any received user word into two multibit user symbols of mutually equal lengths;

b. a first Reed-Solomon encoder fed by said input means for receiving successive first numbers of data symbols generated from said user symbols and having first matrix multiplication means for adding to each first number an associated first series of parity symbols;

c. interleaving means fed by said first Reed-Solomon encoder and containing delay means for imparting respective different delay times to interleave a said first number and associated first series over as many second numbers of symbols as there are symbols in a said first number plus associated first series;

d. a second Reed-Solomon encoder fed by said interleaving means for receiving successive second numbers of symbols and having second matrix multiplication means for adding to each second number an associated second series of parity symbols to produce a third number of code symbols;

e. modulating means fed by said second Reed-Solomon encoder for modulating said code symbols into channel symbols for introduction into a medium for later decoding; characterized in that said input means furthermore comprise a Reed-Solomon encoder fed by said distributing means and having third matrix multiplication means for sector-wise adding to user symbols received a third series of parity symbols, and in that each sector after encoding consists of data symbols equal in number to those of an entire plurality of first numbers of data symbols, for feeding to said first Reed-Solomon encoder.

13. An apparatus as claimed in Claim 12, characterized in that said distributing means have a first output for outputting a more significant user symbol of a user word, and a second output for outputting a less significant user symbol of a user word, in that said first and second outputs are connected to said third Reed-Solomon encoder for sector-wise entering said more significant user symbols therein to said third matrix multiplication means for multiplication thereby as separate from any less significant symbol in the same sector, and vice versa, thereby organizing said sector into two separate planes of more significant symbols and less significant symbols, respectively.

14. An apparatus as claimed in Claim 12 or 13, characterized in that said third Reed-Solomon encoder is provided with sequencing means for within a sector sequentially presenting mutually exclusive first parts of the user symbols of a sector to said third matrix multiplication means to thereby generating associated first subseries of parity symbols, and furthermore, for within a sector sequentially presenting mutually exclusive second parts of the user symbols cum associated first subseries to said third matrix multiplication means to therefore generating associated second subseries of parity symbols, and in that all symbols of any first part are contained in mutually unique second parts, and vice versa.

15. An apparatus as claimed in Claim 12, 13 or 14, characterized in that said third Reed-Solomon encoder is provided with a generator for an additional multisymbol error detection quantity to be contained within a sector of data words.

16. An apparatus as claimed in Claim 15, characterized in that said generator is a CRC generator.

17. A device for information decoding with error correction according to the method claimed in Claim 7, said device comprising:

a. input means connectable to a medium for therefrom receiving a sequence of channel symbols and containing demodulating means for demodulating each channel symbol into a code symbol to constitute a sequence of third numbers of code symbols;

b. first decoding means fed by said input means for receiving a third number of code symbols and having fourth matrix multiplication means for generating to each third number an associated first syndrome symbol group for decoding and if applicable correcting the associated third number to output a second number of symbols smaller than said third number;

c. de-interleaving means fed by said first decoding means and containing delay means for imparting respective different delay times to de-interleave the second number of symbols received and distribute them over as many fourth numbers of symbols as there are symbols in said second number, said second and fourth numbers having the same value;

d. second decoding means fed by said de-interleaving means for receiving a fourth number of symbols and having fifth matrix multiplication means for generating to each fourth number an associated second syndrome symbol group for decoding and, if applicable, correcting the associated fourth number to output the associated first number of symbols smaller than said fourth number;

characterized in that third decoding means are provided, fed by said second decoding means and comprising a third Reed-Solomon decoder having sixth matrix multiplication means for generating further syndrome symbols for decoding and if applicable correcting a sector of data words consisting of an entire plurality of first numbers of data symbols to output user symbols on an output means of said third decoding means.

18. A device as claimed in Claim 17, characterized in that said output means comprise unifying means for reconstituting a user word from a more significant user symbol and less significant user symbol, and in that said sectors are organized into two planes, a first plane of a sector being decoded exclusively to more significant user symbols, and the second plane of a sector being decoded exclusively to less significant user symbols, and in that said third Reed-Solomon decoder is separately operative in each of said two planes from the respective other plane.

19. A device as claimed in Claim 17 or 18, characterized in that said third Reed-Solomon decoder is provided with second sequencing means for within a sector sequentially presenting mutually exclusive first parts of the user symbols of a sector cum an associated first subseries of parity symbols to said third Reed-Solomon decoder, and present mutually exclusive second parts of the user symbols and first subseries of a sector cum an associated second subseries of parity symbols to said third Reed-Solomon decoder; and in that said third Reed-Solomon decoder is separately operative for each of said first and second parts from any respective other first or second part.

20. A device as claimed in Claim 19, characterized in that each first and second subseries consist of two symbols and in that with respect to at least one first or second part said third Reed-Solomon decoder is operative for rendering correctable at least one symbol by means of the associated subseries.

21. A device as claimed in any of the Claim 17 through 20, characterized in that an additional checker is provided for checking a multisymbol error detector quantity within a sector, and in that an output of said checker is connected to a user device output for communicating an insufficient correction signalization.

22. A device as claimed in Claim 21, characterized in that said checker is a CRC checker.

23. An apparatus containing a device as claimed in any of Claims 17 through 22 characterized in that it furthermore contains holding means for holding a storage medium, interrogating means for interrogating said storage medium, drive means for driving said medium along said interrogation means, and interface means for interfacing an output of said interrogation means to an input of said device.

## Patentansprüche

1. Verfahren zur Informationsübertragung mit Fehlerkorrektur für Benutzerwörter, wobei dieses Verfahren folgende Schritte umfasst:

a. Teilung jedes Benutzerworts in ein erstes und ein zweites Mehrbitbenutzersymbol mit untereinander gleichen Längen,

b. Einführung einer Folge erster Anzahlen von Datensymbolen in einen ersten Reed-Solomon-Coder zum Ergänzen jeder ersten Anzahl mit einer ersten Reihe von Paritätssymbolen, wobei diese Datensymbole aus den Benutzersymbolen erzeugt werden,

c. Verschachtelung der Ausgangssymbole des ersten Coders mit Hilfe jeweiliger verschiedener Verzögerungszeiten auf genau soviel zweiter Anzahlen von Symbolen wie es Symbole in einer ersten Anzahl plus der zugeordneten ersten Reihe gibt,

d. Codierung einer zweiten Anzahl von Symbolen in einem zweiten Reed-Solomon-Coder zum

# EP 0 156 440 B1

Ergänzen jeder zweiten Anzahl mit einer zweiten Reihe von Paritätssymbolen zum Erzeugen einer dritten Anzahl von Codesymbolen,

e. Modulation der Codesymbolen in Kanalsymbole zum Einführen in ein Medium für spätere Decodierung,

dadurch gekennzeichnet, dass die Datensymbole durch sektorweise Ergänzung der Benutzersymbole mit einer dritten Folge von Paritätssymbolen in einem dritten Reed-Solomon-Coder erzeugt werden, und dass jeder Sektor (Fig. 3a) nach der Codierung aus Datensymbolen besteht, die zahlenmässig gleich denen einer ganzen Vielzahl erster Anzahlen von Datensymbolen sind.

2. Verfahren nach Anspruch 1, dadurch gekennzeichnet, dass jedes Benutzerwort in ein Benutzersymbol mit höherer Wertigkeit und in ein Benutzersymbol mit niedrigerer Wertigkeit verteilt wird, und dass die Sektoren in zwei Ebenen organisiert sind, wobei eine erste Ebene eines Sektors die Benutzersymbole des Sektors mit höherer Wertigkeit und die zweite Ebene des Sektors die Benutzersymbole dieses Sektors mit niedrigerer Wertigkeit empfängt und dass der dritte Reed-Solomon-Coder in jeder der beiden Ebenen getrennt von der anderen Ebene betriebsfähig ist.

3. Verfahren nach Anspruch 1 oder 2, dadurch gekennzeichnet, dass die dritte Reihe in eine erste Vielzahl untereinander exklusiver erster Unterreihen und in eine zweite Vielzahl untereinander exklusiver zweiter Unterreihen organisiert ist, und dass jede erste Unterreihe (P) einem exklusiven ersten Teil der Benutzersymbole des betreffenden Sektors in bezug auf alle anderen ersten Unterreihen zugegeben wird, und dass jede zweite Unterreihe (Q) einem exklusiven zweiten Teil der Benutzersymbole des betreffenden Sektors zusammen mit der zugeordneten ersten Unterreihe von Paritätssymbole in bezug auf alle anderen zweiten Unterreihen zugegeben wird, und dass alle Symbole eines ersten Teils in gegenseitig einheitlichen zweiten Teilen enthalten sind und umgekehrt.

4. Verfahren nach Anspruch 3, dadurch gekennzeichnet, dass jede Unterreihe aus zwei Paritätssymbolen besteht.

5. Verfahren nach einem der Ansprüche 1 bis 4, dadurch gekennzeichnet, dass eine zusätzlich Mehrsymbolfehlerdetektormenge in einen Sektor von Datensymbolen aufgenommen wird.

6. Verfahren nach Anspruch 5, dadurch gekennzeichnet, dass die Fehlerdetektormenge eine CRC-Prüfmenge ist.

7. Fehlerkorrektur-Decoderverfahren für Datenwörter, die mit dem Verfahren nach Anspruch 1 codiert wurden, wobei dieses Verfahren folgende Schritte enthält:

a. Empfang einer Folge von Kanalsymbolen aus einem Medium mit Bildung einer Folge von dritten Anzahlen von Codesymbolen daraus durch Demodulation,

b. Decodierung, und vorkommendenfalls Korrektur einer dritten Anzahl von Codesymbolen in die zugeordnete kleinere zweite Anzahl von Symbolen in einem ersten Reed-Solomon-Decoder, die dem zweiten Reed-Solomon-Coder zugeordnet ist,

c. Entschachtelung der Ausgangssymbole des ersten Decoders mit Hilfe jeweiliger verschiedener Verzögerungszeiten auf soviel vierte Anzahlen von Symbolen wie es Symbole in der zweiten Anzahl gibt, wobei die zweiten und vierten Anzahlen den gleichen Wert haben,

d. Decodierung, und vorkommendenfalls, Korrektur einer vierten Anzahl von Symbolen nach der zugeordneten kleineren ersten Anzahl von Symbolen in einem zweiten Reed-Solomon-Decoder, die dem ersten Reed-Solomon-Coder zugeordnet ist,

dadurch gekennzeichnet, dass eine ganze Vielzahl der ersten Anzahlen von Symbolen in einen Sektor zum Decodieren, und vorkommendenfalls, zum Korrigieren der Vielzahl in einem ersten Reed-Solomon-Decoder kombiniert werden, der dem dritten Reed-Solomon-Coder zugeordnet ist, um eine erste Ausgangszahl von Benutzersymbolen, die kleiner ist als die Anzahl von Symbolen in einem Sektor wenigstens durch die Anzahl der dritten Reihe von Paritätssymbolen zu erzeugen.

8. Fehlerkorrekturverfahren nach Anspruch 7, dadurch gekennzeichnet, dass die Benutzersymbole paarweise in Benutzerwörter kombiniert werden, dass jedes Benutzerwort aus einem Benutzersymbol mit höherer Wertigkeit und einem Benutzersymbol mit niedrigerer Wertigkeit besteht, dass die Sektoren in zwei Ebenen organisiert sind, dass eine erste Ebene eines Sektors die Benutzersymbole des Sektors mit höherer Wertigkeit enthält und die zweite Ebene die Benutzersymbole des Sektors mit niedrigerer Wertigkeit enthält, und dass der dritte Reed-Solomon-Decoder in jedem der Ebenen getrennt von der jeweiligen anderen Ebene betriebsfähig ist.

9. Fehlerkorrekturverfahren nach Anspruch 7 oder 8, dadurch gekennzeichnet, dass die dritte Reihe von Paritätssymbolen in eine erste Vielzahl untereinander exklusiver erster Unterreihen und in eine zweite Vielzahl untereinander exklusiver zweiter Unterreihen organisiert ist, und dass jede erste Unterreihe einem exklusiven ersten Teil der Benutzersymbole des betreffenden Sektors in bezug auf alle anderen ersten Unterreihe zugegeben wird, und dass jede zweite Unterreihe einem exklusiven zweiten Teil der Benutzersymbole des betreffenden Sektors zusammen mit der zugeordneten ersten Unterreihe von Paritätssymbolen in bezug auf alle anderen Unterreihen zugegeben wird, dass alle Symbole eines ersten Teils in gegenseitig einheitlichen zweiten Teilen enthalten sind, und umgekehrt, und dass der dritte Reed-Solomon-Decoder für jeden des ersten und des zweiten Teils getrennt von jeden anderen jeweiligen ersten und zweiten Teil betriebsfähig ist.

10. Fehlerkorrekturverfahren nach Anspruch 9, dadurch gekennzeichnet, dass die ersten und zweiten

12

Unterreihen aus je zwei Symbolen bestehen, und dass in bezug auf wenigstens einen ersten oder zweiten Teil wenigstens ein Symbol von der zugeordneten Unterreihe korrigierbar gemacht wird.

11. Fehlerkorrekturverfahren nach einem der Ansprüche 7 bis 10, dadurch gekennzeichnet, dass eine zusätzliche Mehrsymbolfehlerdetektormenge in einen Sektor von Datensymbolen aufgenommen wird, und dass beim Decodieren ein ungenügender Fehlerschutz, wie er von der Fehlerdetektormenge detektierbar ist, von einer Benutzereinrichtung signalisiert wird.

12. Anordnung zur Informationsübertragung mit Fehlerkorrektur entsprechend dem Verfahren nach Anspruch 1, wobei diese Anordnung folgende Elemente enthält

a. Eingangsmittel einschliesslich Verteilermittel zum Empfangen von Benutzerwörtern und zum Verteilen jedes empfangenen Benutzerwortes in zwei Mehrbitbenutzersymbole mit untereinander gleichen Längen,

b. einen ersten Reed-Solomon-Coder, die von den genannten Eingangsmitteln zum Empfangen aufeinanderfolgender erster Anzahlen von Datensymbolen aus den Benutzersymbolen gespeist wird und erste Matrixvervielfachungsmittel zum Ergänzen jeder ersten Anzahl mit einer zugeordneten ersten Reihe von Paritätssymbolen enthält,

c. Verschachtelungsmittel, die von ersten Reed-Solomon-Coder gespeist werden, und Verzögerungsmittel zum Ermöglichen jeweiliger verschiedener Verzögerungszeiten zum Verschachteln einer ersten Anzahl und einer zugeordneten ersten Reihe auf soviel zweite Anzahlen von Symbolen enthält, wie es Symbole in einer ersten Anzahl plus zugeordneter erster Reihe enthalten sind,

d. einen zweiten Reed-Solomon-Coder, der von Verschachtelungsmitteln zum Empfangen aufeinanderfolgender zweite Anzahlen von Symbolen gespeist wird und zweite Matrixvervielfachungsmittel zum Ergänzen jeder zweiten Anzahl mit einer zugeordneten zweiten Reihe von Paritätssymbolen enthält, um eine dritte Anzahl von Codesymbolen zu erzeugen,

e. Modulationsmittel, die vom zweiten Reed-Solomon-Coder zum Modulieren der Codesymbole in Kanalsymbole zum Einführen in ein Medium für spezielle Decodierung gespeist werden,

dadurch gekennzeichnet, dass die Eingangsmittel weiter einen Reed-Solomon-Coder enthalten, der von Verteilermittel gespeist wird und dritte Matrixvervielfachungsmittel zum sektorweisen Ergänzen der Benutzersymbole aus einer dritten Reihe von Paritätssymbolen enthält, und dass jeder Sektor nach dem Codieren aus Datensymbolen besteht, die zahlenmässig gleich denen einer ersten Vielzahl von ersten Anzahlen von Datensymbolen sind, um sie einen ersten Reed-Solomon-Coder zuzuleiten.

13. Anordnung nach Anspruch 12, dadurch gekennzeichnet, dass die Verteilermittel einen ersten Ausgang zum Ausgeben eines Benutzersymbols eines Benutzerworts mit höherer Wertigkeit und einen zweiten Ausgang zum Ausgeben eines Benutzersymbols eines Benutzerworts mit niedrigerer Wertigkeit enthält, dass die ersten und zweiten Ausgänge mit dem dritten Reed-Solomon-Coder zum sektorweise Einführen der Benutzersymbole des Coders mit höherer Wertigkeit in die dritten Matrixvervielfachungsmittel zum Vervielfachen getrennt von jedem Symbol im gleichen Sektor mit niedrigerer Wertigkeit verbunden sind und umgekehrt, wobei dieser Sektor in zwei getrennten Ebenen mit Symbolen höherer Wertigkeit und Symbolen niedrigerer Wertigkeit verteilt ist.

14. Anordnung nach Anspruch 12 oder 13, dadurch gekennzeichnet, dass der dritte Reed-Solomon-Coder mit Aufreihungsmittel versehen ist, um in einem Sektor gegenseitig exklusive erste Teile der Benutzersymbole eines Sektors ein dritten Matrixvervielfachungsmitteln sequentiell zuzuführen, um die zugeordneten ersten Unterreihen von Paritätssymbolen zu erzeugen und weiter um in einem Sektor gegenseitig exklusive zweite Teile der Benutzersymbole einschliesslich der zuegeordneten ersten Unterreihen dem dritten Matrixvervielfachungsmitteln sequentiell zuzuführen, um zugeordnete zweite Unterreihen von Paritätssymbolen zu erzeugen, und dass alle Symbole jedes ersten Teiles in untereinander einheitlichen zweiten Teilen enthalten sind un umgekehrt.

15. Anordnung nach Anspruch 12, 13 oder 14, dadurch gekennzeichnet, dass der dritte Reed-Solomon-Coder mit einem Generator für eine zusätzliche Mehrsymbolfehlerdetektormenge ausgerüstet ist, welche Menge in einem Sektor von Datenwörtern enthalten ist.

16. Anordnung nach Anspruch 15, dadurch gekennzeichnet, dass der Generator ein CRC-Generator ist.

17. Gerät für Informationsdecodierung mit Fehlerkorrektur zur Verwendung mit dem Verfahren nach Anspruch 7, wobei dieses Gerät folgende Elemente enthält:

a. Eingangsmittel, die mit einem Medium verbindbar sind, um daraus eine Reihe von Kanalsymbolen zu empfangen, und die Demodulationsmittel zum Demodulieren jedes Kanalsymbols in ein Codesymbol enthalten, um eine Reihe von dritten Anzahlen von Codesymbolen zu bilden,

b. erste Decodermittel, die von den Eingangsmitteln für den Empfang einer dritten Anzahl von Codesymbolen gespeist werden und vierte Matrixvervielfachungsmittel zum Erzeugen bei jeder dritten Anzahl eine zugeordnete erste Syndromsymbolgruppe zum Decodieren enthalten, und vorkommendenfalls zum Korrigieren der zugeordneten dritten Anzahl, um eine zweite Anzahl von Symbolen kleiner als diese dritte Anzahl auszugeben,

c. Entschachtelungsmittel, die von den ersten Decodierungsmitteln gespeist werden und Verzögerungsmittel zum Auslösen jeweiliger verschiedener Verzögerungszeiten zum Entschachteln der empfangenen zweiten Anzahl von Symbolen und zum Verteilen dieser Anzahl auf soviele vierte Anzahlen von Symbolen, wie es Symbolen in der zweiten Anzahl gibt, enthalten, wobei die zweiten und vierten Anzahlen den gleichen Wert haben,

d. zweite Decodierungsmittel, die von den Entschachtelungsmitteln zum Empfang einer vierten Anzahl von Symbolen gespeist werden und fünfte Matrixvervielfachungsmittel zum Erzeugen bei jeder vierten Anzahl eine zugeordnete zweite Syndromsymbolgruppe von Decodieren und vorkommendenfalls zum Korrigieren der zugeordneten vierten Anzahl enthalten, um die zugeordnete erste Anzahl von Symbolen kleiner als diese vierte Anzahl auszugeben,

dadurch gekennzeichnet, dass dritte Decodierungsmittel vorgesehen sind, die von den zweiten Decodierungsmitteln gespeist werden und einen dritten Reed-Solomon-Decoder mit sechsten Matrixvervielfachungsmitteln zum Erzeugen weiterer Syndromsymbole für die Decodierung und vorkommendenfalls zum Korrigieren eines Sektors von Datenwörtern enthalten, die aus einer ganzen Vielzahl erster Anzahlen von Datensymbolen besteht, um Benutzersymbole an einem Ausgangsmittel der dritten Decodierungsmittel auszugeben.

18. Gerät nach Anspruch 17, dadurch gekennzeichnet, dass die Ausgangsmittel Vereinigungsmittel zur Neubildung eines Benutzerworts aus einem Benutzersymbol mit höherer Wertigkeit und aus einem Benutzersymbol mit niedrigerer Wertigkeit enthalten, und dass die Sektoren in zwei Ebenen organisiert sind, wobei eine erste Ebene eines Sektors ausschliesslich im Benutzersymbole mit höherer Wertigkeit und die zweite Ebene eines Sektors ausschliesslich im Benutzersymbole mit niedrigerer Wertigkeit decodiert werden, und dass der dritte Reed-Solomon-Decoder in jedem der beiden Ebenen getrennt von der jeweiligen anderen Ebene betriebsfähig ist.

19. Gerät nach Anspruch 17 oder 18, dadurch gekennzeichnet, dass der dritte Reed-Solomon-Decoder mit zweiten Aufreihungsmitteln ausgerüstet ist, um in einem Sektor gegenseitig exklusive erste Teile der Benutzersymbole eines Sektors zusammen mit einer zugeordneten ersten Unterreihe von Paritätssymbolen einem dritte Reed-Solomon-Decoder sequentiell zuzuführen, und gegenseitig exklusive zweite Teile der Benutzersymbole und erste Unterreihen eines Sektors zusammen mit einem zugeordneten zweiten Unterreihe von Paritätssymbolen einem dritten Reed-Solomon-Decoder zuzuführen, und dass der dritte Reed-Solomon-Decoder für jeden der ersten und zweiten Teilen getrennt von einem betreffenden anderen ersten oder zweiten Teil betriebsfähig ist.

20. Gerät nach Anspruch 19, dadurch gekennzeichnet, dass eine erste und eine zweite Unterreihe aus zwei Symbolen besteht und dass in bezug auf wenigstens einen ersten oder zweiten Teil der dritte Reed-Solomon-Decoder dazu betriebsfähig ist, wenigstens ein Symbol mit Hilfe der zugeordneten Unterreihe korrigierbar zu machen.

21. Gerät nach einem der Ansprüche 17 bis 20, dadurch gekennzeichnet, dass ein zusätzlicher Prüfer zum Prüfen einer Mehrsymbolfehlerdetektormenge in einem Sektor vorgesehen ist, und dass ein Ausgang dieses Prüfers mit einem Benutzereinrichtungsausgang zum Kommunizieren einer unzulänglichen Korrektursignalisierung verbunden ist.

22. Gerät nach Anspruch 21, dadurch gekennzeichnet, dass der Prüfer ein CRC-Prüfer ist.

23. Anordnung mit einem Gerät nach einem der Ansprüche 17 bis 22, dadurch gekennzeichnet, dass diese Anordnung weiter Haltemittel zum Halten eines Speichermediums, Abfragemittel zum Abfragen des Speichermediums, Antriebsmittel zum Antreiben dieses Mediums entlang der Abfragemittel und Schnittstellenmittel zur Bildung von Schnittstellen zwischen einem Ausgang der Abfragemittel und einem Eingang des Geräts enthält.

**Revendications**

1. Procédé de transmission d'information avec correction d'erreurs pour des mots d'utilisateur comprenant les étapes qui consistent à:

a. diviser chaque mot d'utilisateur en un premier et un second symbole d'utilisateur multibit de longueurs mutuellement égales;

b. introduire une succession de premiers nombres de symboles de données dans un premier codeur de Reed-Solomon pour ajouter à chaque premier nombre une première série de symboles de parité, les symboles de données étant produits à partir des symboles d'utilisateur;

c. imbriquer les symboles de sortie du premier codeur à l'aide de retards différents respectifs sur autant de seconds nombres qu'il y a de symboles dans un premier nombre plus une première série associée;

d. coder un second nombre de symboles dans un second codeur de Reed-Solomon pour ajouter à chaque second nombre une seconde série de symboles de parité en vue de produire un troisième nombre de symboles de codes;

e. moduler les symboles de codes en des symboles de canaux en vue d'une introduction dans un milieu pour un décodage ultérieur,

caractérisé en ce que les symboles de données sont générés par adjonction par secteur, aux symboles d'utilisateur, d'une troisième série de symboles de parité dans un troisième codeur de Reed-Solomon et en ce que chaque secteur (Fig. 3a), après codage, est constitué de symboles de données égaux en nombre à ceux d'une pluralité entière de premiers nombres de symboles de données.

2. Procédé suivant la revendication 1, caractérisé en ce que chaque mot d'utilisateur est divisé en un symbole d'utilisateur plus significatif et un symbole d'utilisateur moins significatif et en ce que les secteurs sont organisés en deux plans, un premier plan d'un secteur recevant les symboles d'utilisateur plus significatifs du secteur et le second plan recevant les symboles d'utilisateur moins significatifs du secteur, et le troisième codeur de Reed-Solomon peut opérer séparément dans chacun des deux plans à partir de l'autre plan respectif.

3. Procédé suivant la revendication 1 ou 2, caractérisé en ce que la troisième série est organisée en une première pluralité de premières sous-séries mutuellement exclusives et en une seconde pluralité de secondes sous-séries mutuellement exclusives, et en ce que chaque première sous-série (P) est ajoutée à une première partie des symboles d'utilisateur du secteur en question exclusive par rapport à toutes les autres premières sous-séries, et en ce que chaque seconde sous-série (Q) est ajoutée à une seconde partie des symboles d'utilisateur du secteur en question, avec la première sous-série associée de symboles de parité, exclusive par rapport à toutes les autres secondes sous-séries, et en ce que tous les symboles d'une première partie sont contenus dans des secondes parties mutuellement uniques et inversement.

4. Procédé suivant la revendication 3, caractérisé en ce que chaque sous-série est constituée de deux symboles de parité.

5. Procédé suivant l'une quelconque des revendications 1 à 4, caractérisé en ce qu'une quantité de détection d'erreurs multisymbole supplémentaire est incluse dans un secteur de symboles de données.

6. Procédé suivant la revendication 5, caractérisé en ce que la quantité de détection d'erreurs est une quantité de contrôle de redondance cyclique (CRC).

7. Procédé de décodage à correction d'erreurs pour des mots d'utilisateur qui ont été codés conformément au procédé de la revendication 1, ce procédé comprenant les étapes qui consistent à:

a. recevoir d'un milieu une séquence de symboles de canaux et former à partir de celle-ci par démodulation une séquence de troisièmes nombres de symboles de codes;

b. décoder et, si possible, corriger un troisième nombre de symboles de codes en un deuxième nombre de symboles plus petit associé dans un premier décodeur de Reed-Solomon associé au second codeur de Reed-Solomon;

c. désimbriquer les symboles de sortie du premier décodeur à l'aide de retards différents respectifs sur autant de quatrièmes nombres de symboles qu'il y a de symboles dans le deuxième nombre, les deuxièmes et quatrièmes nombres ayant la même valeur;

d. décoder et, si possible, corriger un quatrième nombre de symboles en un premier nombre de symboles plus petit associé dans un second décodeur de Reed-Solomon associé au premier codeur de Reed-Solomon,

caractérisé en ce qu'une entière pluralité des premiers nombres de symboles est combinée en un secteur pour décoder et, si possible, corriger ladite pluralité dans un troisième décodeur de Reed-Solomon associé au troisième codeur de Reed-Solomon en vue de produire un nombre de sortie de symboles d'utilisateur qui soit inférieur au nombre de symboles dans un secteur d'au moins le nombre de la troisième série de symboles de parité.

8. Procédé de correction d'erreurs suivant la revendication 7, caractérisé en ce que les symboles d'utilisateur sont combinés par paires en mots d'utilisateur, chaque mot d'utilisateur est constitué d'un symbole d'utilisateur plus significatif et d'un symbole d'utilisteur moins significatif, les secteurs sont organisés dans deux plans par le fait qu'un premier plan d'un secteur comprend les symboles d'utilisateur plus significatifs du secteur et que le second plan comprend les symboles d'utilisateur moins significatifs du secteur, et le troisième décodeur de Reed-Solomon peut agir séparément dans chacun des plans à partir de l'autre plan correspondant.

9. Procédé de correction d'erreurs suivant la revendication 7 ou 8, caractérisé en ce que la troisième série de symboles de parité est organisée en une première pluralité de premières sous-séries mutuellement exclusives et en une seconde pluralité de secondes sous-séries mutuellement exclusives, en ce que chaque première sous-série est ajoutée à une première partie des symboles d'utilisateur du secteur en question exclusive par rapport à toutes les autres premières sous-séries, en ce que chaque seconde sous-série est ajoutée à une seconde partie des symboles d'utilisateur du secteur en question, avec la première sous-série associée de symboles de parité, exclusive par rapport à toutes les autres sous-séries, en ce que tous les symboles parties mutuellement uniques et inversement et en ce que le troisième décodeur de Reed-Solomon peut opérer séparément pour chacune des premières et secondes parties depuis n'importe quelle autre première et seconde partie respective.

10. Procédé de correction d'erreurs suivant la revendication 9, caractérisé en ce que la première et la seconde sous-série sont constituées chacune de deux symboles et en ce que, par rapport à au moins une première ou une seconde partie, au moins un symbole est rendu apte à être corrigé par la sous-série associée.

11. Procédé de correction d'erreurs suivant l'une quelconque des revendications 7 à 10, caractérisé en ce qu'une quantité de détection d'erreurs multisymbole supplémentaire est incluse dans un secteur de symbole de données et en ce que, lors du décodage, une protection contre les erreurs insuffisante pouvant être détectée par la quantité de détection d'erreurs est signalée à un dispositif d'utilisateur.

12. Appareil pour la transmission d'information avec correction d'erreurs selon le procédé de la revendication 1, cet appareil comprenant:

a. un moyen d'entrée avec un moyen de distribution pour recevoir des mots d'utilisateur et distribuer tout mot d'utilisateur reçu dans deux symboles d'utilisateur multibit de longueurs mutuellement égales;

b. un premier codeur de Reed-Solomon alimenté par le moyen d'entrée pour recevoir des premiers nombres successifs de symboles de données générés à partir des symboles d'utilisateur et comportant un premier moyen de multiplication matricielle pour ajouter à chaque premier nombre une première série associée de symboles de parité;

c. des moyens d'imbrication alimentés par le premier codeur de Reed-Solomon et contenant des moyens à retard pour introduire des retards différents respectifs en vue d'imbriquer un premier nombre et une première série associée sur autant de seconds nombres de symboles qu'il y a de symboles dans un premier nombre plus une première série associée;

d. un second codeur de Reed-Solomon alimenté par les moyens d'imbrication pour recevoir des seconds nombres successifs de symboles et comportant un second moyen de multiplication matricielle pour ajouter à chaque second nombre une seconde série associée de symboles de parité en vue de produire un troisième nombre de symboles de codes;

e. des moyens modulateurs alimentés par le second codeur de Reed-Solomon pour moduler les symboles de codes en des symboles de canaux à introduire dans un milieu en vue d'un décodage ultérieur, caractérisé en ce que les moyens d'entrée comprennent, en outre, un codeur de Reed-Solomon alimenté par les moyens de distribution et comportant un troisième moyen de multiplication matricielle pour additionner par secteur aux symboles d'utilisateur reçus une troisième série de symboles de parité, et en ce que chaque secteur après le codage est constitué de symboles de données égaux en nombre à ceux d'une entière pluralité de premiers nombres de symboles de données, à appliquer au premier codeur de Reed-Solomon.

13. Appareil suivant la revendication 12, caractérisé en ce que les moyens de distribution comportent une première sortie destinée à fournir un symbole d'utilisateur plus significatif d'un mot d'utilisateur, et une seconde sortie destinée à fournir un symbole d'utilisateur moins significatif d'un mot d'utilisateur, en ce que la première et la seconde sortie sont connectées au troisième codeur de Reed-Solomon pour introduire par secteur les symboles d'utilisateur plus significatifs dans le troisième moyen de multiplication matricielle en vue d'une multiplication, séparément de tout symbole moins significatif dans le même secteur et inversement, le secteur étant ainsi organisé en deux plans séparés de symboles plus significatifs et de symboles moins significatifs, respectivement.

14. Appareil suivant la revendication 12 ou 13, caractérisé en ce que le troisième codeur de Reed-Solomon est pourvu de moyens séquenceurs pour, dans un secteur, présenter séquentiellement, des premières parties mutuellement exclusives des symboles d'utilisateur d'un secteur au troisième moyen de multiplication matricielle afin de générer ainsi des premières sous-séries associées de symboles de parité et, de plus, pour dans un secteur, présenter séquentiellement des secondes parties mutuellement exclusives des symboles d'utilisateur avec la première sous-série associée au troisième moyen de multiplication matricielle pour générer ainsi des secondes sous-séries associées de symboles de parité et en ce que tous les symboles d'une première partie quelconque sont contenus dans des secondes parties mutuellement uniques et inversement.

15. Appareil suivant la revendication 12, 13 ou 14, caractérisé en ce que le troisième codeur de Reed-Solomon est pourvu d'un générateur pour une quantité de détection d'erreurs multisymbole supplémentaire destinée à être contenue dans un secteur de mots de données.

16. Appareil suivant la revendication 15, caractérisé en ce que le générateur est un générateur CRC.

17. Dispositif pour le décodage d'information avec correction d'erreurs suivant le procédé selon la revendication 7, ce dispositif comprend:

a. un moyen d'entrée pouvant être connecté à un milieu pour en recevoir une séquence de symboles de canaux et contenant un moyen démodulateur pour démoduler chaque symbole de canal en un symbole de code pour constituer une séquence de troisièmes nombres de symboles de codes;

b. un premier moyen de décodage alimenté par les moyens d'entrée pour recevoir un troisième nombre de symboles de codes et comportant un quatrième moyen de multiplication matricielle pour générer, pour chaque troisième nombre, un premier groupe associé de symboles de syndrome afin de décoder et si possible de corriger le troisième nombre associé pour fournir un deuxième nombre de symboles plus petit que le troisième;

d. des moyens de désimbrication alimentés par le premier moyen de décodage et contenant des moyens à retard pour communiquer des retards différents respectifs en vue de désimbriquer le second nombre de symboles reçu et de le distribuer sur autant de quatrièmes nombres de symboles qu'il y a de symboles dans le deuxième nombre, les deuxièmes et quatrièmes nombres ayant la même valeur;

e. un deuxième moyen de décodage alimenté par les moyens de désimbrication pour recevoir un quatrième nombre de symboles et comportant un cinquième moyen de multiplication matricielle pour générer, pour chaque quatrième nombre, un second groupe de symboles de syndrome associés pour décoder et, si possible, corriger le quatrième nombre associé en vue de fournir le premier nombre de symboles associés inférieur au quatrième nombre, caractérisé en ce qu'un troisième moyen de décodage est prévu, alimenté par le deuxième moyen de décodage et comprenant un troisième décodeur de Reed-Solomon comportant un sixième moyen de multiplication matricielle pour générer d'autres symboles de syndrome afin de décodeur et, si possible, de corriger un secteur de mots de données constitué d'une entière pluralité de premiers nombres de symboles de données, afin de fournir des symboles d'utilisateur sur un moyen de sortie des troisièmes moyens de décodage.

18. Dispositif suivant la revendication 17, caractérisé en ce que les moyens de sortie comprennent des moyens d'unification pour reconstituer un mot d'utilisateur à partir d'un symbole d'utilisateur plus significatif et d'un symbole d'utilisateur moins significatif et en ce que les secteurs sont organisés dans deux plan, un premier plan d'un secteur étant décodé exclusivement en des symboles d'utilisateur plus significatifs et le second plan d'un secteur étant décodé exclusivement en des symboles d'utilisateur moins significatifs et en ce que le troisième décodeur de Reed-Solomon peut opérer séparément dans chacun des deux plans à partir de l'autre plan respectif.

19. Dispositif suivant la revendication 17 ou 18, caractérisé en ce que le troisième décodeur de Reed-Solomon est pourvu de seconds moyens séquenceurs pour, dans un secteur, présenter séquentiellement des premières parties mutuellement exclusives des symboles d'utilisateur d'un secteur avec une première sous-série associée de symboles de parité au troisième décodeur de Reed-Solomon, et pour présenter des secondes parties mutuellement exclusives des symboles d'utilisateur et de la première sous-série d'un secteur avec une seconde sous-série associée de symboles de parité au troisième décodeur de Reed-Solomon, et en ce que le troisième décodeur de Reed-Solomon opère séparément pour chacune des première et seconde partie à partir de n'importe quelle autre première ou seconde partie respective.

20. Dispositif suivant la revendication 19, caractérisé en ce que chaque première et seconde sous-série est constituée de deux symboles et en ce que, par rapport à au moins une première ou une seconde partie, le troisième décodeur de Reed-Solomon peut intervenir pour rendre au moins un symbole apte à être corrigé à l'aide de la sous-série associée.

21. Dispositif suivant l'une quelconque des revendications 17 à 20, caractérisé en ce qu'un contrôleur supplémentaire est prévu pour vérifier une quantité de détection d'erreurs multisymbole dans un secteur et en ce qu'une sortie du contrôleur est connectée à une sortie de dispositif d'utilisateur pour communiquer une signalisation de correction insuffisante.

22. Dispositif suivant la revendication 21, caractérisé en ce que le contrôleur est un contrôleur CRC.

23. Appareil contenant un dispositif suivant l'une quelconque des revendications 17 à 22, caractérisé en ce qu'il contient, en outre, un moyen de retenue pour retenir un milieu de stockage, un moyen d'interrogation pour interroger le milieu de stockage, un moyen d'entraînement pour entraîner le milieu le long du moyen d'interrogation et un moyen d'interface pour connecter une sortie du moyen d'interrogation à une entrée du dispositif.

EP 0 156 440 B1

100

1 FRM (588 b)

DB(14 b)

RB    DB

30 31 32 F S 0 1 2 3 ------- 12 13 14 15 16 17 18 19 ------- 28 29 30 31 32 F S 0 1 2 3 ---

(24b)

AUDI DAT        PAR        AUDI DAT        PAR

RB(3b)        CNTRL DSPL

## FIG.1

| | 102 | DB(0) 104 | DB 1..12,17..28 106 | 108 |
|---|---|---|---|---|
| 1 BLCK | | | | |
| 0 th FRM | FS | SYNC PAT | COD (6 SMPL x 2 CHAN) | PAR |
| 1st FRM | FS | SYNC PAT | COD (6 SMPL x 2 CHAN) | PAR |
| 2 nd FRM | FS | P Q R S T U V W | COD (6 SMPL x 2 CHAN) | PAR |
| 3 rd FRM | FS | P Q R S T U V W | COD (6 SMPL x 2 CHAN) | PAR |
| | | | CHAN | |
| 97 th FRM | FS | P Q R S T U V W | (6 SMPL x2 CHAN) | PAR |

24b        8b        16x6x2b        4x8b

## FIG.3

FIG.2

| | |
|---|---|
| 110 | SYNC : 12 byt |
| 112 | HEDR 4 byt |
| 114 | DAT 2048 byt |
| 116 | EDC 4 byt |
| 118 | SPAC 8 byt |
| 120 | P PAR 172 byt |
| 122 | Q PAR 104 byt |

1 sect

## FIG. 3a

RAM 16

RAM CONTR 15

P DEC 32

Q DEC 33

CRC CHEC 34

GTE 35

31

## FIG. 10

| | L - ch | | R - ch | |
|---|---|---|---|---|
| | L · · · M | L · · · M | | |
| 1 | 0 0 0 0 0 0 0 0 | 1 1 1 1 1 1 1 1 | 1 1 1 1 1 1 1 1 | 1 1 1 1 1 1 1 1 |
| 2 | 1 1 1 1 1 1 1 1 | 1 1 1 1 1 1 1 1 | 1 1 1 1 1 1 1 1 | 1 1 1 1 1 1 1 1 |
| 3 | 1 1 1 1 1 1 1 1 | 1 1 1 1 1 1 1 1 | 1 1 1 1 1 1 1 1 | 0 0 0 0 0 0 0 0 |
| 4 | MIN | SEC | SECT | MOD |
| 5 | D 0001 | D 0002 | D 0003 | D 0004 |
| 6 | D 0005 | D 0006 | D 0007 | D 0008 |
| 7 | D 0009 | D 0010 | D 0011 | D 0012 |
| 8 | D 0013 | D 0014 | D 0015 | D 0016 |
| 9 | D 0017 | D 0018 | D 0019 | D 0020 |
| 10 | D 0021 | D 0022 | D 0023 | D 0024 |
| 11 | D 0025 | D 0026 | D 0027 | D 0028 |
| 12 | D 0029 | D 0030 | D 0031 | D 0032 |
| 13 | D 0033 | D 0034 | D 0035 | D 0036 |
| . | | | | |
| 586 | D 2325 | D 2326 | D 2327 | D 2328 |
| 587 | D 2329 | D 2330 | D 2331 | D 2332 |
| 588 | D 2333 | D 2334 | D 2335 | D 2336 |

FIG.4

EP 0 156 440 B1

FIG.5

| | L-ch | M | R-ch | M |
|---|---|---|---|---|
| 1 | 0 0 0 0 0 0 0 1 1 1 1 1 1 1 1 | | 1 1 1 1 1 1 1 1 1 1 1 1 1 1 | 1 |
| 2 | 1 1 1 1 1 1 1 1 1 1 1 1 1 1 | | 1 1 1 1 1 1 1 1 1 1 1 1 1 1 | 1 |
| 3 | 1 1 1 1 1 1 1 1 1 1 1 1 1 1 | | 0 0 0 0 0 0 0 1 1 1 1 1 1 1 | 0 |
| 4 | W 0000 | | W 0001 | |
| 5 | W 0002 | | W 0003 | |
| 6 | W 0004 | | W 0005 | |
| 7 | W 0006 | | W 0007 | |
| 8 | W 0008 | | W 0009 | |
| 9 | W 0010 | | W 0011 | |
| 10 | W 0012 | | W 0013 | |
| 11 | W 0014 | | W 0015 | |
| 12 | W 0016 | | W 0017 | |
| 13 | W 0018 | | W 0019 | |
| ⋯ | | | | |
| 586 | W 1164 | | W 1165 | |
| 587 | W 1166 | | W 1167 | |
| 588 | W 1168 | | W 1169 | |

5

| | 0 | 1 | 2 | 3 | 4 | · | · | · | · | 40 | 41 | 42 |
|---|---|---|---|---|---|---|---|---|---|---|---|---|
| 0 | 0000 | 0001 | 0002 | 0003 | 0004 | .... | .... | .... | .... | 0040 | 0041 | 0042 |
| 1 | 0043 | 0044 | 0045 | 0046 | 0047 | .... | .... | .... | .... | 0083 | 0084 | 0085 |
| 2 | 0086 | 0087 | 0088 | 0089 | 0090 | .... | .... | .... | .... | 0126 | 0127 | 0128 |
| 3 | 0129 | 0130 | 0131 | 0132 | 0133 | .... | .... | .... | .... | 0169 | 0170 | 0171 |
| 4 | 0172 | 0173 | 0174 | 0175 | 0176 | .... | .... | .... | .... | 0212 | 0213 | 0214 |
| 5 | | | | | | | | | | | | |
| 6 | | | | | | | | | | | | |
| 7 | | | | | | | | | | | | |
| 8 | | | | | | | | | | | | |
| 9 | | | | | | | | | | | | |
| 10 | | | | | | | | | | | | |
| 11 | | | | | | | | | | | | |
| 12 | | | | | | | | | | | | |
| · | | | | | | | | | | | | |
| · | | | | | | | | | | | | |
| · | | | | | | | | | | | | |
| · | | | | | | | | | | | | |
| · | | | | | | | | | | | | |
| 22 | 0946 | 0947 | 0948 | 0949 | 0950 | .... | .... | .... | .... | 0986 | 0987 | 0988 |
| 23 | 0989 | 0990 | 0991 | 0992 | 0993 | .... | .... | .... | .... | 1029 | 1030 | 1031 |
| 24 | 1032 | 1033 | 1034 | 1035 | 1036 | .... | .... | .... | .... | 1072 | 1073 | 1074 |
| 25 | 1075 | 1076 | 1077 | 1078 | 1079 | .... | .... | .... | .... | 1115 | 1116 | 1117 |
| 26 | 1118 | 1119 | 1120 | 1121 | 1122 | .... | .... | 1143 | | | | |
| 27 | 1144 | 1145 | 1146 | 1147 | 1148 | .... | .... | 1169 | | | | |

Q SEQ

P SEQ

HDDR & SR'S DAT

P PAR

Q PAR

FIG.6

EP 0 156 440 B1

| N\M | 0 | 1 | 2 | 3 | 4 | . | . | . | 40 | 41 | 42 | 0.0 | 0.1 |
|---|---|---|---|---|---|---|---|---|---|---|---|---|---|
| 0 | 0000 | 0044 | 0088 | 0132 | 0176 | · · · · | · · · · | · · · · | 0642 | 0686 | 0730 | 1118 | 1144 |
| 1 | 0043 | 0087 | 0131 | 0175 | 0219 | · · · · | · · · · | · · · · | 0685 | 0729 | 0773 | 1119 | 1145 |
| 2 | 0086 | 0130 | 0174 | 0218 | 0262 | · · · · | · · · · | · · · · | 0728 | 0772 | 0816 | 1120 | 1146 |
| 3 | 0129 | 0173 | 0217 | 0261 | 0305 | · · · · | · · · · | · · · · | 0771 | 0815 | 0859 | 1121 | 1147 |
| 4 | 0172 | 0216 | 0260 | 0304 | 0348 | · · · · | · · · · | · · · · | 0814 | 0858 | 0902 | 1122 | 1148 |
| . | · · · · | · · · · | · · · · | · · · · | · · · · | | | | · · · · | · · · · | · · · · | · · · · | · · · · |
| . | · · · · | · · · · | · · · · | · · · · | · · · · | | | | · · · · | · · · · | · · · · | · · · · | · · · · |
| . | · · · · | · · · · | · · · · | · · · · | · · · · | | | | · · · · | · · · · | · · · · | · · · · | · · · · |
| . | · · · · | · · · · | · · · · | · · · · | · · · · | | | | · · · · | · · · · | · · · · | · · · · | · · · · |
| . | · · · · | · · · · | · · · · | · · · · | · · · · | | | | · · · · | · · · · | · · · · | · · · · | · · · · |
| . | · · · · | · · · · | · · · · | · · · · | · · · · | | | | · · · · | · · · · | · · · · | · · · · | · · · · |
| . | · · · · | · · · · | · · · · | · · · · | · · · · | | | | · · · · | · · · · | · · · · | · · · · | · · · · |
| 22 | 0946 | 0990 | 1034 | 1078 | 0004 | · · · · | · · · · | · · · · | 0470 | 0514 | 0558 | 1140 | 1166 |
| 23 | 0989 | 1033 | 1077 | 0003 | 0047 | · · · · | · · · · | · · · · | 0513 | 0557 | 0601 | 1141 | 1167 |
| 24 | 1032 | 1076 | 0002 | 0046 | 0090 | · · · · | · · · · | · · · · | 0556 | 0600 | 0644 | 1142 | 1168 |
| 25 | 1075 | 0001 | 0045 | 0089 | 0133 | · · · · | · · · · | · · · · | 0599 | 0643 | 0687 | 1143 | 1169 |

FIG.7

FIG.8

FIG.9